# EUROPÄISCHE PATENTSCHRIFT

(11) **EP 1 352 255 B1**
(45) Veröffentlichungstag und Bekanntmachung des Hinweises auf die Patenterteilung: **24.05.2006**
(21) Anmeldenummer: 02711772.0
(22) Anmeldetag: 14.01.2002
(51) Int. Cl.: G01R 27/02, G01N 27/406

(54) **VORRICHTUNG ZUR BESTIMMUNG DES INNENWIDERSTANDES EINER LINEAREN SAUERSTOFFSONDE**
DEVICE FOR DETERMINING THE INTERNAL RESISTANCE OF A LINEAR OXYGEN PROBE
DISPOSITIF DE DETERMINATION DE LA RESISTANCE INTERIEURE D'UNE SONDE A OXYGENE LINEAIRE (SONDE LAMBDA)

(30) Priorität: 16.01.2001 DE 10101755
(43) Veröffentlichungstag der Anmeldung: 15.10.2003
(73) Patentinhaber: SIEMENS AKTIENGESELLSCHAFT, 80333 München (DE)
(72) Erfinder: BOLZ, Stephan, 93102 Pfatter (DE)
(86) Internationale Anmeldenummer: PCT/DE2002/000081
(87) Internationale Veröffentlichungsnummer: WO 2002/056034

(56) Entgegenhaltungen:
- US-A- 4 135 381
- US-A- 4 472 262
- US-A- 5 106 481

## Beschreibung

Die Erfindung betrifft eine Vorrichtung zur Bestimmung des Innenwiderstandes einer linearen Sauerstoffsonde (Lambdasonde) einer Brennkraftmaschine gemäß den Merkmalen des Oberbegriffs von Anspruch 1.

Der dynamische Widerstand der Diffusionsbarriere einer linearen Lambdasonde - darstellbar als temperaturabhängige, komplexe Reaktanz mit mehreren RC-Gliedern - die im Abgastrakt einer Brennkraftmaschine zur Ermittlung des der Brennkraftmaschine zugeführten Kraftstoff-Luft-Gemischs angeordnet ist, weist eine Temperaturabhängigkeit auf, was zu Fehlern im Übersetzungsverhältnis, d.h., im Meßergebnis führt. Man begegnet dem durch Messung der Sondentemperatur und deren Regelung auf einen konstanten Wert (beispielsweise 750°C) mittels eines in der Lambdasonde eingebauten Heizelementes. Aus Kostengründen wird dabei auf ein separates Thermoelement zur Temperaturmessung verzichtet; man mißt statt dessen den stark temperaturabhängigen Innenwiderstand Rpvs der Lambdasonde.

Eine bekannte Vorrichtung zur Bestimmung des Innenwiderstandes Rpvs einer linearen Sauerstoffsonde (Lambdasonde) ist die Beaufschlagung des Sondenanschlusses Vs+ mit einem Wechselstrom von beispielsweise 500*µ*Ass (Spitze-Spitze) und einer Frequenz von 3kHz. Am Innenwiderstand Rpvs fällt ein Wechselspannungssignal ab. Bei Rpvs = 100Ω: 500µAss*100Ω= 50mVss. Dieses Wechselspannungssignal wird verstärkt und gleichgerichtet und kann dann einem Analog/Digital-Konverter eines Mikroprozessors zur Temperaturregelung der Sauerstoffsonde zugeführt werden.

Während der Aufheizphase ist der Sondenwiderstand Rpvs sehr hochohmig (etwa 1MΩ bei 200°C) und die Amplitude des an ihm abfallenden Wechselspannungssignals entsprechend groß (maximal bis 5Vss).

Um nun frühzeitig den Innenwiderstand Rpvs erfassen zu können, muß der Verstärker (Rpvs_Amp ) eine geringe Verstärkung haben. Ein typischer Meßbereich wäre 0...24*R0 (Bereich 2: kalte Sonde), wobei R0 dem nominalen (Soll-)Sondenwiderstand (z.B. 100Ω bei 750°C) entspricht. Im normalen Betrieb ist eine größere Spreizung des Meßbereiches gefordert, z. B. 0...6*R0 (Bereich 1: warme Sonde).

Bei bekannten Ausführungen erfolgt die Veränderung der Meßbereiche durch eine Umschaltung der Verstärkung im Verstärker (Rpvs_Amp), beispielsweise *4 (Anheizphase, Bereich 2) und *16 (Normalbetrieb, Bereich 1). Der Wert für den Sondeninnenwiderstand Rpvs wird dadurch (nach Verstärkung und Gleichrichtung) in eine Ausgangsspannung im Bereich von 0...4,8V umgewandelt. Fügt man dieser Gleichspannung noch eine Offsetspannung von 0,1V hinzu, so ergibt sich ein Ausgangsspannungsbereich von 0,1V...4,9V. Dieser Spannungsbereich kann im Gleichrichter verarbeitet werden (Betriebsspannung 5V) und nutzt den Bereich des Analog/Digital-Konverters aus.

Ein gravierender Nachteil dieser Lösung ist allerdings die große Amplitude des Wechselspannungssignals während der Aufheizphase (maximal 5Vss). Dies kann bei einigen Sondentypen zur Schädigung der Keramik führen (sog. Blackening) und ist deshalb nicht akzeptabel. Ein typischer Maximalwert ist ca. 2Vss. Dem entsprechend darf das Wechselspannungssignal erst bei genügend warmer - niederohmiger - Sonde zugeschaltet werden.

Um die Aufheizphase trotzdem überwachen zu können, behilft man sich mit einer Beobachtung des Pumpstromes Ip (ist die Sonde niederohmig genug, so kann auch ein Pumpstrom Ip fliessen und die Ip-Regelung stabilisiert sich). Dieses Verfahren ist allerdings ungenau und mit erheblichem Softwareaufwand im Mikrocontroller verbunden.

Ein weiteres Problem ergibt sich dadurch, daß bei Inbetriebnahme der Schaltung der Oszillator nun angehalten werden muß. Sein Ausgang steht auf 0V oder 5V. Der zu diesem Zeitpunkt sehr hochohmige Sondenanschluß Vs+ ist über den Widerstand Rv und den Kondensator Cv mit dem Oszillatorausgang verbunden. Da der Kondensator Cv entladen ist, folgt das Potential am Sondenanschluß Vs+ dem Potential des Oszillatorausgangs und liegt nun ebenfalls auf 0V oder 5V.

Dieser Wert liegt aber außerhalb des nominalen Arbeitsbereiches. Eine nicht dargestellte Diagnoseschaltung erkennt dies als Kurzschluß nach Masse bzw. nach Batteriespannung und würde einen (nicht vorhandenen) Fehler (Scheinfehler) melden, der durch aufwendige Softwaremaßnahmen unterdrückt werden muß.

Bei einer bekannten Vorrichtung zur Überwachung der Temperatur eines Sauerstoffsensors (US 4, 135, 381) wird ein Innenwiderstand mit einem von einem Oszillator erzeugten Wechselstrom beaufschlagt, wobei die über dem Sondeninnenwiderstand abfallende Spannung nach einer Verstärkung und Gleichrichtung als Regelsignal für eine Sondenheizung verwendet wird.

Es ist Aufgabe der Erfindung, eine Vorrichtung zur Bestimmung des Innenwiderstandes einer linearen Sauerstoffsonde zu schaffen, bei welcher der Oszillator auch während der Aufheizphase an die Auswerteschaltung angeschlossen ist und in dieser Phase die Amplitude des Wechselspannungssignals innerhalb ihres Sollbereichs bleibt und einen Meßwert für den Sondeninnenwiderstand liefert.

Diese Aufgabe wird erfindungsgemäß durch eine Vorrichtung mit den in Anspruch 1 genannten Merkmalen gelöst.

Ein Ausführungsbeispiel nach der Erfindung wird nachstehend anhand einer schematischen Zeichnung näher erläutert. Es zeigen:
- Figur 1: eine bekannte Vorrichtung zum Betrieb einer linearen Lambdasonde mit einer bekannten Vorrichtung zur Bestimmung des Sondeninnenwiderstandes Rpvs,
- Figur 2: eine erfindungsgemäße Vorrichtung zur Bestimmung des Sondeninnenwiderstandes Rpvs,
- Figur 3: die Oszillator-Ausgangssignale der erfindungsgemäßen Vorrichtung,
- Figur 4: das Ausgangssignal VRpvs in Abhängigkeit vom Sondeninnenwiderstand Rpvs,
- Figur 5: Ausgangssignal VRpvs und Spannung an der Sonde im Verstärkungsbereich 2 (Aufheizphase), und
- Figur 6: Ausgangssignal VRpvs und Spannung an der Sonde im Verstärkungsbereich 1 (Normalbetrieb).

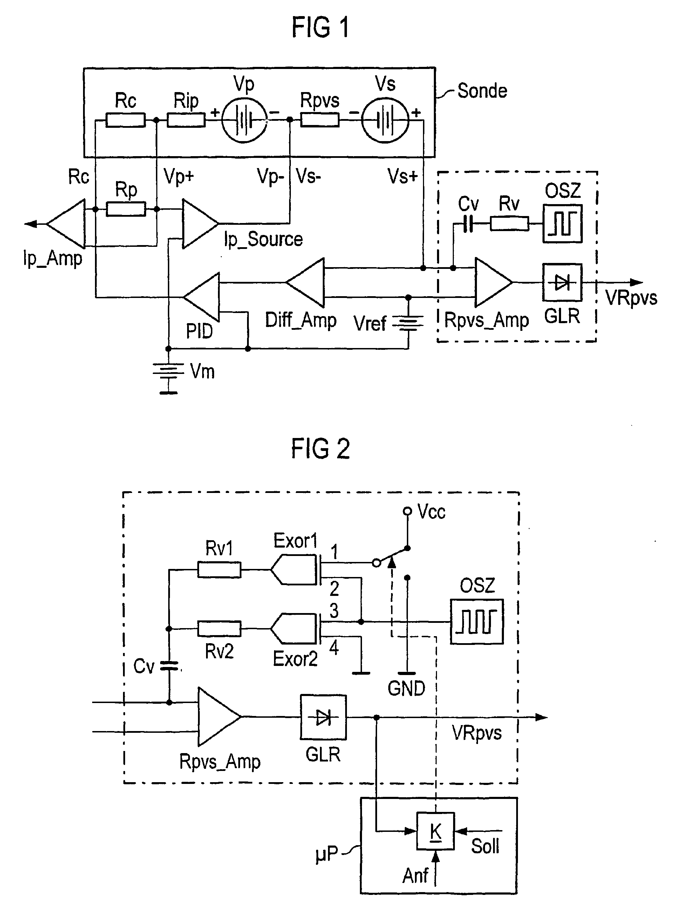

Figur 1 zeigt eine an sich bekannte Vorrichtung zum Betrieb einer linearen Lambdasonde mit einer bekannten Vorrichtung zur Bestimmung des Sondeninnenwiderstandes.

Links oben befindet sich die Sonde mit
- dem Kalibrierwiderstand Rc (Anschlüsse Rc, Vp+),
- der Pumpzelle (Anschlüsse Vp+, Vp-) mit dem Ersatzwiderstand Rip und der Polarisationsspannung Vp, und
- der Meßzelle (Anschlüsse Vs+, Vs-) mit der Nennspannung Vs und dem Sondeninnenwiderstand Rpvs.

Unterhalb der Sonde befindet sich eine bekannte Auswerteschaltung (Ip Regelung) mit
- Differenzverstärker (Diff_Amp),
- Referenzspannungsquelle (Vref),
- Regelverstärker (PID),
- Mittenspannungsquelle (Vm),
- Pumpstromquelle (Ip_Source) und
- Parallelwiderstand Rp.

Rechts von Sonde und Auswerteschaltung ist, punktiert eingerahmt, eine bekannte Vorrichtung zur Messung des Sondeninnenwiderstandes Rpvs mit einem Oszillator OSZ, einem Widerstand Rv, einem Entkoppelkondensator Cv, sowie einem Verstärker Rpvs_Amp und einem Gleichrichter GLR dargestellt.

Die Lambdasonde und ihre Auswerteschaltung sind im Prinzip bekannt und sollen nicht weiter erläutert werden.

Zur Messung des Sondeninnenwiderstandes Rpvs wird die Sonde mit einem im Oszillator OSZ erzeugten Meßsignal, beispielsweise einem rechteckförmigen Wechselstrom von 500*µ*Ass (Spitze-Spitze) und einer Frequenz von 3kHz, beaufschlagt. Über den hochohmigen Widerstand Rv und den Entkoppelkondensator Cv wird das Signal dem ersten Anschluß Vs+ der Lambdasonde zugeleitet. Am Innenwiderstand Rpvs, der beispielsweise gerade 100Ω betrage, entsteht dann eine Rechteckspannung von 500*µ*Ass*100Ω = 50mVss. Diese Rechteckspannung wird in einem Verstärker Rpvs_Amp verstärkt und in einem Gleichrichter GLR gleichgerichtet und kann dann als Gleichspannung VRpvs einem nicht dargestellten Mikroprozessor als Regelsignal für die Temperaturregelung der Lambdasonde zugeführt werden. Die Nachteile dieser Schaltung sind oben dargelegt.

Figur 2 zeigt in einem punktierten Rahmen die Schaltung einer erfindungsgemäßen Vorrichtung zur Bestimmung des Sondeninnenwiderstandes Rpvs. In dieser Schaltung finden sich der Oszillator OSZ, der Verstärker Rpvs_Amp, der Gleichrichter GLR und der Entkoppelkondensator Cv aus Figur 1 wieder.

Der Widerstand Rv ist durch zwei Widerstände Rv1 und Rv2 ersetzt und zusätzlich sind zwei Exor-Glieder Exor1 und Exor2 (Exklusiv-ODER-Glieder, beispielsweise vom Typ 74HC86) und ein Umschalter S vorgesehen.

Der Ausgang des Oszillators OSZ, dessen Ausgangssignal als Rechteckstrom dem Sondeninnenwiderstand Rpvs aufgeprägt werden soll, ist mit dem Eingang 2 von Exor1 und mit dem Eingang 3 von Exor2 verbunden. Eingang 4 von Exor2 liegt auf Lowpotential (Bezugspotential GND), und Eingang 1 von Exor1 ist über den Umschalter S an Lowpotential (GND) oder an Highpotential (Betriebsspannungspotential Vcc = 5V) legbar.

Der Ausgang von Exor1 ist über einen Widerstand Rvl, der Ausgang von Exor2 über einen Widerstand Rv2 mit dem Entkoppelkondensator Cv verbunden, der in bekannter Weise mit dem Sondeninnenwiderstand Rpvs verbunden ist und zum Verstärker Rpvs_Amp und weiter zum Gleichrichter GLR führt.

Die Widerstände Rv1 und Rv2 werden folgendermaßen bestimmt:
Rv1 = Z/{0,5*(1-N)}, (= 26.67kΩ),
Rv2 = Z/{0,5*(1+N)}, (= 16.00kΩ),
mit
N = Spannungsverhältnis Bereich 1/Bereich 2 (z.B.: 0.25),
Z = Gesamtwiderstand: Rv1 parallel zu Rv2 (z.B.: 10kΩ).

Die Vorrichtung arbeitet folgendermaßen:

Beim Einschalten der Betriebsspannung Vcc=5V wird zunächst die Sondenheizung eingeschaltet und Bereich 2 selektiert, da im kalten Zustand Rpvs>100kΩ ist. Eingang 1 von Exor1 liegt auf Highpotential = 5V. Exor1 arbeitet als Inverter, Exor2 als nichtinvertierender Buffer; Exor1 und Exor2 arbeiten gegenphasig. An ihren Ausgängen erscheint das 3kHz Rechtecksignal mit entgegengesetzter Phasenlage d.h., Ausgang Exor1 = Low (0V), Ausgang Exor2 = High (+5V) oder umgekehrt.

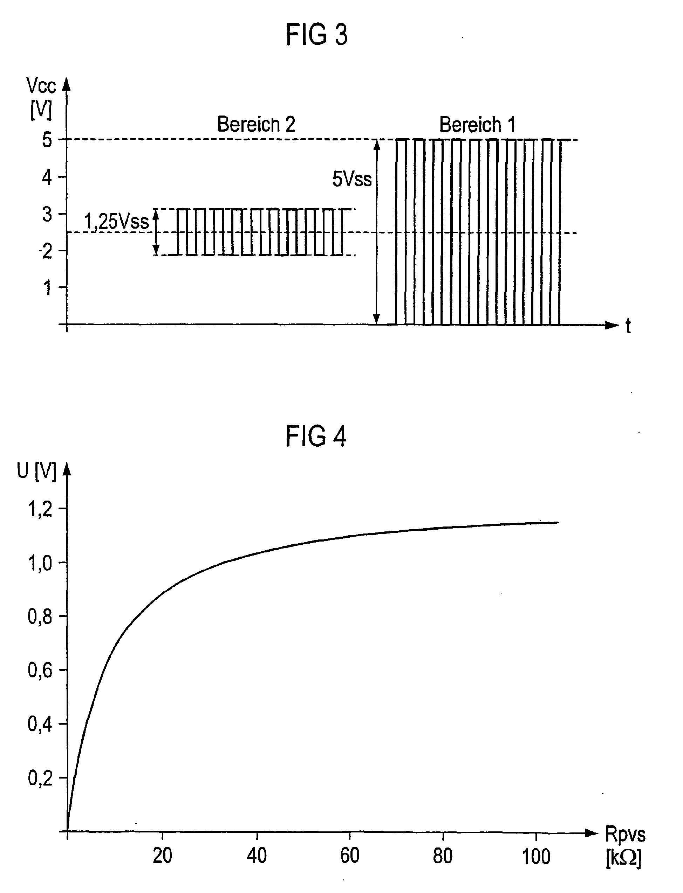

Die Widerstände Rv1 und Rv2 bilden in diesem Fall einen Spannungsteiler mit einem Innenwiderstand von 10kΩ. Am Verbindungspunkt von Rv1 und Rv2 ergibt sich eine Wechselspannung, die - abhängig vom Widerstandsteilerverhältnis - entweder Vcc[Rv1/(Rv1+Rv2)] = 1,87V oder Vcc[Rv2/(Rv1+Rv2)] = 3,13V = 1,25Vss beträgt (siehe Figur 3: Bereich 2). Entsprechend bestimmt sich der in den Sondeninnenwiderstand Rpvs fließende Wechselstrom.

Die Ausgangswechselspannung am Verbindungspunkt der beiden Widerstände Rv1 und Rv2, also am Abgriff des Spannungsteilers, liegt zwischen z.B. 3,13V und 1,87V = 1,25Vss im Leerlauf oder je nach dem Wert von Rpvs - abhängig von seiner Temperatur - dann entsprechend niedriger.

Über den Entkoppelkondensator Cv wird dieser Wert dem Eingang des Verstärkers Rpvs_Amp zugeführt. Dadurch wird eine irrtümliche Fehlererkennung der Schaltung vermieden.

Sinkt im Bereich 2 der Sondeninnenwiderstand Rpvs unter einen vorgegebenen Wert, beispielsweise auf 600Ω (bzw. das Ausgangssignal VRpvs auf einen entsprechenden Spannungswert), so wird über den Schalter S der Eingang 1 von Exor1 von Highpotential nach Lowpotential und damit auf Bereich 1 umgeschaltet, d.h., die Verstärkung um den Faktor 4 angehoben.

Am Eingang 1 von Exor1 liegt nun Lowpotential GND = 0V. Exor1 und Exor2 arbeiten beide als nichtinvertierende Buffer gleichphasig, d.h., an ihren Ausgängen erscheint das 3kHz-Rechtecksignal (im Leerlauf 5Vss) mit gleicher Phasenlage: entweder beide gleichzeitig auf Low- oder auf Highpotential. Die Widerstände Rv1 und Rv2 erscheinen parallel geschaltet, Rv1=16kΩ, Rv2=26,67 KΩ, der gemeinsame Widerstand Rv1 || Rv2= 10kΩ. Entsprechend fließt über sie ein Wechselstrom von 5Vss/10kΩ=500 *µ*Ass in den Sondenwiderstand Rpvs. Es ergibt sich eine Wechselspannung von 5Vss (Figur 3: Bereich 1).

Mit dem zur Gleichspannungsentkopplung eingefügten Entkopplungskondensator Cv liegt am Sondeninnenwiderstand eine Wechselspannungsquelle mit einem Innenwiderstand von 10kΩ und einer Leerlaufspannung von 1,25Vss (Bereich 2) oder von 5Vss (Bereich 1) an.

Die Umschaltung des Umschalters S bewirkt ein Komparator K, der im Bereich 2 die Ausgangsspannung VRpvs mit einem vorgegebenen Sollwert Soll vergleicht. Solange VRpvs>Soll ist, bleibt der Ausgang 1 auf Highpotential gelegt; wird VRpvs<Soll, so wird der Ausgang 1 auf Lowpotential umgeschaltet (Bereich 1). In dieser Stellung verharrt er dann, wobei der Sondeninnenwiderstand Rpvs über das Ausgangssignal VRpvs auf 100Ω/750°C geregelt wird, bis zum Abschalten der Betriebsspannung.

Der Komparator K ist Teil einer integrierten Schaltung, beispielsweise eines Mikroprozessors *µ*P, durch einen Rahmen symbolisiert. In dieser integrierten Schaltung kann auch die im punktierten Rahmen befindliche Vorrichtung, wenigstens teilweise, oder auch die gesamte in Figur 1 dargestellte Auswerteschaltung integriert sein. Beim Einschalten der Betriebsspannung (Betriebsbeginn) wird der Komparator durch einen Befehl Anf so gesetzt, daß der Umschalter S den Eingang 1 von Exor1 mit Highpotential (Bereich 2) verbindet.

Figur 3 zeigt die Oszillator-Ausgangssignale in den Bereichen 1 (5Vss) und 2 (1,25Vss).

Figur 4 zeigt die Signalamplitude der am Sondeninnenwiderstand Rpvs bzw. am Eingang des Verstärkers Rpvs_Amp abfallenden Spannung in Abhängigkeit vom Sondeninnenwiderstand Rpvs. Dieser hat einen Wert >>100kΩ bei einer Temperatur T=20°C, und etwa 100kΩ bei T≈200°C (rechte Seite des Diagramms); am Verstärkereingang liegt dann eine Spannung von etwa 1,16Vss, maximal 1,25Vss.

Liegt der Sondeninnenwiderstand Rpvs auf seinem Nominalwert 100Ω bei T=750°C, auf welchen die Temperaturregelung erfolgt (linke Seite des Diagramms nahe dem Nullpunkt), so liegt am Verstärkereingang eine Spannung von etwa 0,35Vss. Die Temperatur T steigt mit abnehmendem Widerstandswert, auf der Abszisse also von rechts nach links, an.

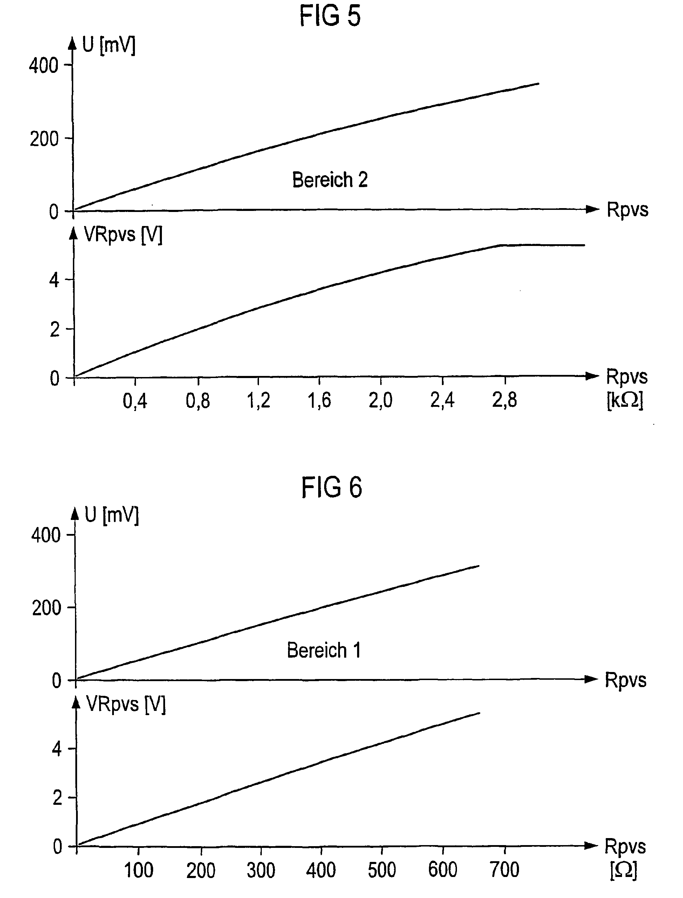

Figur 5 zeigt die Signalamplituden am Sondeninnenwiderstand Rpvs bzw. am Eingang des Verstärkers Rpvs_Amp (oben) und darunter die am Ausgang des Gleichrichters GLR abgreifbare Gleichspannung VRpvs, jeweils im Bereich 2, siehe Figur 4. Ausgehend von einem Betriebsbeginn mit einer Sondentemperatur T=20°C und Rpvs>>100kΩ ist der Verstärkerausgang zunächst in Sättigung, die Sonde wird beheizt und erwärmt sich. Wird der Sondeninnenwiderstand Rpvs <2,4kΩ (oben), so verringert sich die Ausgangsspannung VRpvs (unten). Wird Rpvs≤600Ω, so wird auf Bereich 1 umgeschaltet, siehe Figur 6.

Figur 6 zeigt oben die Signalamplitude am Sensor und darunter die am Ausgang abgreifbare Gleichspannung VRpvs im Bereich 1, dem eigentlichen Regelbereich für die Sondenheizung, um den Sondeninnenwiderstand auf Rpvs=100Ω zu regeln.

Die erfindungsgemäße Schaltung weist folgende Vorteile auf:
- Die Verstärkungsumschaltung für die Bereiche 1 und 2 erfolgt durch eine Amplitudenumschaltung des Wechselspannungssignals: Bereich 1: 0....6R0 (Normaler Betrieb); Amplitude = 5Vss. Bereich 2: 0...24R0 (Sondenhochlauf); Amplitude = 5Vss/4 = 3,12V - 1,87V = ±0,625V = 1,25Vss, siehe Figur 3 (R0 = Rpvs bei 750°C = 100Ω).
- Die Bereiche sind mittels zweier Widerstände sehr einfach zu definieren.
- Der Quellwiderstand ist - unabhängig vom Bereich - stets konstant.
- Die Schaltung ist einfach zu integrieren bzw. mit Standardkomponenten herstellbar.
- Die maximal zulässige Sondenspannung von ±2V (4Vss) bei kalter Sonde wird nicht mehr überschritten.

## Patentansprüche

1. Vorrichtung zur Bestimmung des Innenwiderstandes (Rpvs) einer linearen Sauerstoffsonde einer Brennkraftmaschine, mit einem Oszillator (OSZ) zum Erzeugen eines Wechselstroms, der über einen Entkopplungskondensator (Cv) dem Sondeninnenwiderstand (Rpvs) über einen Sondenanschluß (Vs+) aufgeprägt wird und der eine dem Sondeninnenwiderstand (Rpvs) proportionale Spannung (VRpvs) als Regelsignal für eine Sondenheizung erzeugt, die in einem Verstärker (Rpvs_Amp) verstärkt und anschließend in einem Gleichrichter (GLR) gleichgerichtet wird,
**dadurch gekennzeichnet,**
**daß** ein Spannungsteiler (Rv1, Rv2) vorgesehen ist, dessen beiden äußeren Anschlüssen das Ausgangssignal des Oszillators (OSZ) zugeführt wird, welches an dessen Abgriff eine Spannung erzeugt, die den durch den Sondeninnenwiderstand (Rpvs) fließenden Wechselstrom generiert,
**daß** das Ausgangssignal des Oszillators (OSZ) den beiden Anschlüssen des Spannungsteilers (Rv1, Rv2) ab dem Einschalten der Betriebsspannung solange mit zueinander entgegengesetzter Phasenlage (Bereich 2) zugeführt wird, wodurch die Sauerstoffsonde aufgeheizt wird, bis die dem Sondeninnenwiderstand (Rpvs) proportionale Spannung (VRpvs) am Ausgang des Verstärkers (Rpvs_Amp) einen vorgegebenen Sollwert (Soll) unterschreitet, und
**daß** ab diesem Zeitpunkt das Ausgangssignal des Oszillators (OSZ) den beiden Anschlüssen des Spannungsteilers (Rv1, Rv2) mit gleicher Phasenlage (Bereich 1) zugeführt wird.

2. Vorrichtung nach Anspruch 1, **dadurch gekennzeichnet,**
**daß** ein erstes Exclusiv-Oder-Glied (Exor1) vorgesehen ist, dessen einer Eingang (1) über einen Umschalter (S) mit dem Highpotential(Vcc) oder dem Lowpotential (GND) einer Betriebsspannung verbindbar ist, und dessen anderer Eingang (2) mit dem Ausgang des Oszillators (OSZ) verbunden ist,
**daß** ein zweites Exclusiv-Oder-Glied (Exor2) vorgesehen ist, dessen einer Eingang (3) mit dem Ausgang des Oszillators (OSZ) verbunden ist, und dessen anderer Eingang (4) mit Lowpotential (GND) verbunden ist,
**daß** der Ausgang des ersten Exclusiv-Oder-Gliedes (Exor1) mit dem Ausgang des zweiten Exclusiv-Oder-Gliedes (Exor2) über den Spannungsteiler aus einer Reihenschaltung eines ersten (Rv1) und eines zweiten Widerstandes (Rv2) verbunden ist, und
**daß** der Abgriff des Spannungsteilers, der Verbindungspunkt der beiden Widerstände (Rv1, Rv2) über den Entkoppelkondensator (Cv) mit dem Sondenanschluß (Vs+) und dem Eingang des Verstärkers (Rpvs_Amp) verbunden ist.

3. Vorrichtung nach Anspruch 1 oder 2, **dadurch gekennzeichnet,**
**daß** ein Komparator (K) vorgesehen ist, dem die Ausgangsspannung (VRpvs), ein vorgegebener Sollwert (VRpvs), und ein Befehl (Anf) zugeführt sind,
welcher den Eingang (1) des ersten Exclusiv-Oder-Gliedes (Exor1) über den Umschalter (S) mit dem Highpotential (Vcc) der Betriebsspannung verbindet (Bereich 2), wenn bei Betriebsbeginn die Betriebsspannung eingeschaltet wird, und solange die Ausgangsspannung (VRpvs) größer als der Sollwert (Soll) ist, und
welcher den Eingang (1) des ersten Exclusiv-Oder-Gliedes (Exor1) über den Umschalter (S) auf Lowpotential(GND) der Betriebsspannung legt (Bereich 1), sobald die Ausgangsspannung (VRpvs) kleiner als der Sollwert (Soll) ist.

4. Vorrichtung nach Anspruch 3, **dadurch gekennzeichnet, daß** der Sollwert (Soll) so gewählt ist, daß nach dem Umschalten des Umschalters (S) von Highpotential (Vcc) auf Lowpotential (GND) die Ausgangsspannung (VRpvs) kleiner als das Highpotential (Vcc) ist.

## Claims

1. Device for determining the internal resistance (Rpvs) of a linear oxygen probe in an internal combustion engine, with an oscillator (OSZ) for generating an alternating current which is applied to the internal resistance (Rpvs) of the probe across a probe connector (Vs+) via a decoupling capacitor (Cv) and which generates a voltage (VRpvs) proportional to the internal resistance (Rpvs) of the probe as a control signal for a probe heating process, which is amplified in an amplifier (Rpvs_Amp) and is subsequently rectified in a rectifier (GLR),
**characterised in that**
a voltage divider (Rv1, Rv2) is provided, the two external connectors of which are fed the output signal of the oscillator (OSZ), which generates a voltage at the latter's pick-off, said voltage generating the alternating current flowing through the internal resistance (Rpvs) of the probe, the output signal of the oscillator (OSZ) is fed to the two connectors of the voltage divider (Rv1, Rv2) once the operating voltage has been activated with an opposing phase relation (region 2), as a result of which the oxygen probe is heated, until the voltage (VRpvs) proportional to the probe internal resistance (Rpvs) drops below a predetermined target value (Soll) at the output of the amplifier (Rpvs_Amp) and from this point in time the output signal of the oscillator (OSZ) is fed to the two connectors of the voltage divider (Rv1, Rv2) with the same phase relation (region 1).

2. Device according to claim 1, **characterised in that**
a first exclusive OR element (Exor1) is provided, the one input (1) of which can be connected to the high potential (Vcc) or the low potential (GND) of an operating voltage via a selector switch (S), and the other input (2) of which is connected to the output of the oscillator (OSZ)
a second exclusive OR element (Exor2) is provided, the one input (3) of which is connected to the output of the oscillator (OSZ) and the other input (4) of which is connected to the low potential (GND),
the output of the first exclusive OR element (Exor1) is connected to the output of the second exclusive OR element (Exor2) via the voltage divider from a series circuit comprising a first (Rv1) and a second resistance (Rv2), and the pick-off of the voltage divider, the connection point of the two resistances (Rv1, Rv2) is connected to the probe connector (Vs+) and the input of the amplifier (Rpvs_Amp) via the decoupling capacitor (Cv).

3. Device according to claim 1 or 2, **characterised in**
**that** a comparator (K) is provided, which is fed the output voltage (VRpvs), a predetermined target value (VRpvs), and a command (Anf),
which connects the input (1) of the first exclusive OR element (Exor1) to the high potential (Vcc) of the operating voltage (region 2) via the selector switch (S), if the operating voltage is activated at the start of operation and as long as the output voltage (VRpvs) is larger than the target value (Soll), and which sets the input (1) of the first exclusive OR element (Exor1) to the low potential (GND) of the operating voltage (region 1) via the selector switch (S), as soon as the output voltage (VRpvs) is smaller than the target value (Soll).

4. Device according to claim 3, **characterised in that** the target value (Soll) is selected such that after the selector switch (S) has switched over from high potential (Vcc) to low potential (GND), the output voltage (VRpvs) is smaller than the high potential (Vcc).

## Revendications

1. Dispositif pour déterminer la résistance interne (Rpvs) d'une sonde à oxygène linéaire d'un moteur à combustion interne, comprenant un oscillateur (OSZ) destiné à produire un courant alternatif qui est appliqué à travers un condensateur de découplage (Cv) à la résistance interne (Rpvs) de la sonde, à une connexion (Vs+) de la sonde et qui produit une tension (VRpvs) proportionnelle à la résistance interne (Rpvs) de la sonde constituant un signal de régulation pour un chauffage de sonde, qui est amplifié dans un amplificateur (Rpvs_Amp) et ensuite redressé dans un redresseur (GLR),
**caractérisé**
**en ce qu'**il est prévu un diviseur de tension (Rv1, Rv2) aux deux connexions extérieures duquel le signal de sortie de l'oscillateur (OSZ) est transmis, et qui produit à sa prise une tension qui génère le courant alternatif qui circule à travers la résistance interne (Rpvs) de la sonde,
**en ce que** le signal de sortie de l'oscillateur (OSZ) est envoyé aux deux connexions du diviseur de tension (Rv1, Rv2) à partir de la mise en circuit de la tension de fonctionnement, avec des positions de phase mutuellement opposées (plage 2), ce qui chauffe la sonde à oxygène, jusqu'à ce que la tension (VRpvs) proportionnelle à la résistance interne (Rpvs) de la sonde qui apparaît à la sortie de l'amplificateur (Rpvs_Amp) devienne inférieure à une valeur de consigne prédéterminée (Soll), et
**en ce qu'** à partir de cet instant, le signal de sortie de l'oscillateur (OSZ) est transmis aux deux connexions du diviseur de tensions (Rv1, Rv2) avec la même position de phase (plage 1).

2. Dispositif selon la revendication 1, **caractérisé en ce qu'**il est prévu
un premier élément OU exclusif (Exor1) dont une entrée (1) peut être reliée au moyen d'un commutateur (S) au potentiel haut (Vcc) ou au potentiel bas (GND) d'une tension de service et dont l'autre entrée (2) est reliée la sortie de l'oscillateur (OSZ),
un deuxième élément OU exclusif (Exor2) dont une entrée (3) est reliée à la sortie de l'oscillateur (OSZ) et dont l'autre entrée (4) est reliée à un potentiel bas (GND),
**en ce que** la sortie du premier élément OU exclusif (Exor1) est reliée à la sortie du deuxième élément OU exclusif (Exor2) par l'intermédiaire du diviseur de tension composé d'un circuit série d'une première résistance (Rv1) et d'une deuxième résistance (Rv2), et
**en ce que** la prise du diviseur de tension, le point de jonction des deux résistances (Rv1, Rv2), est reliée à travers le condensateur de découplage (Cv) à la connexion (Vs+) de la sonde et à l'entrée de l'amplificateur (Rpvs_Amp).

3. Dispositif selon la revendication 1 ou 2, **caractérisé en ce qu'**il est prévu un comparateur (K) auquel sont transmis la tension de sortie (VRpvs), une valeur de consigne prédéterminée (VRpvs) et un ordre (Anf), qui relie l'entrée (1) du premier élément OU exclusif (Exor1), par l'intermédiaire du commutateur (S), au potentiel haut (Vcc) de la tension de service (plage 2) lorsque, la tension de service est mise en circuit au début du service et aussi longtemps que la tension de sortie (VRpvs) est supérieure à la valeur de consigne (Soll), et qui met l'entrée (1) du premier élément OU exclusif (Exor1), par l'intermédiaire du commutateur (S), au potentiel bas (GND) de la tension de service (plage 1) dès que la tension de sortie (VRpvs) est plus petite que la valeur de consigne (Soll).

4. Dispositif selon la revendication 3, **caractérisé en ce que** la valeur de consigne (Soll) est choisie de manière qu'après le basculement du commutateur (S) du potentiel haut (Vcc) au potentiel bas (GND), la tension de sortie (VRpvs) soit plus petite que le potentiel haut (Vcc).
